# EUROPÄISCHE PATENTSCHRIFT

(11) **EP 2 238 624 B1**
(45) Veröffentlichungstag und Bekanntmachung des Hinweises auf die Patenterteilung: **05.06.2013**
(21) Anmeldenummer: 08871711.1
(22) Anmeldetag: 17.12.2008
(51) Int. Cl.: H01L 31/0352, H01L 31/105, H01L 31/18

(54) **STRAHLUNGSEMPFÄNGER UND VERFAHREN ZUR HERSTELLUNG EINES STRAHLUNGSEMPFÄNGERS**
RADIATION RECEPTOR AND METHOD FOR THE PRODUCTION OF THE RADIATION RECEPTOR
RÉCEPTEUR DE RAYONNEMENT ET PROCÉDÉ DE FABRICATION D'UN RÉCEPTEUR DE RAYONNEMENT

(30) Priorität: 31.01.2008 DE 102008006987
(43) Veröffentlichungstag der Anmeldung: 13.10.2010
(73) Patentinhaber: OSRAM Opto Semiconductors GmbH, 93055 Regensburg (DE)
(72) Erfinder: BUTENDEICH, Rainer, 93059 Regensburg (DE); WINDISCH, Reiner, 93186 Pettendorf (DE)
(74) Vertreter: Epping - Hermann - Fischer
(86) Internationale Anmeldenummer: PCT/DE2008/002126
(87) Internationale Veröffentlichungsnummer: WO 2009/094966

(56) Entgegenhaltungen:
- EP-A- 1 643 565
- WO-A-2006/097189
- WO-A-2006/128407
- WO-A-2007/085218
- DE-A1- 3 533 146
- DE-A1-102004 004 765
- GB-A- 2 228 824
- JP-A- 58 105 569
- US-A- 4 677 289
- US-A- 5 518 934
- US-A- 6 091 126
- US-A1- 2006 042 677
- US-A1- 2006 118 914

## Beschreibung

Die vorliegende Anmeldung betrifft einen Strahlungsempfänger und ein Verfahren zur Herstellung eines Strahlungsempfängers.

Diese Patentanmeldung beansprucht die Priorität der deutschen Patentanmeldung 10 2008 006 987.6.

Bei Farbsensoren, die auf Silizium basieren, werden meist unterschiedliche Farbfilter verwendet, um Farbanteile in den Spektralbereichen Rot, Grün und Blau zu messen. Zusätzlich kann ein weiterer Glasfilter erforderlich sein, um Infrarotstrahlung zu filtern. Diese externen Filter können hohe Herstellungskosten hervorrufen und erschweren die Herstellung kompakter Bauelemente.

Aus der Druckschrift EP 1 643 565 A2 ist ein Strahlungsdetektor mit einer Mehrzahl von Detektorelementen bekannt, die jeweils einen zur Signalerzeugung vorgesehenen aktiven Bereich aufweisen und monolithisch in einen Halbleiterkörper des Strahlungsdetektors integriert sind. Das in einem ersten Detektorelement zu erzeugende Signal ist getrennt von einem in einem zweiten Detektorelement zu erzeugenden Signal abgreifbar.

In der Druckschrift DE 10 2004 004 765 A1 ist ein Mischfarben-Sensor mit aktiven Zonen als Photodioden beschrieben. Eine np-Trenndiode dient als niederohmiger Verbindungswiderstand zwischen zwei pn-Übergängen.

Weitere Strahlungsdetektoren sind in den Druckschriften US 6,091,126, US 5,518,934, GB 2 228 824 A, DE 35 33 146 A1, US 4,677,289 und US 2006/0042677 A1 beschrieben.

Aus den Druckschriften US 2006/0118914 A1, WO 2006/097189 A1 und WO 2007/085218 A1 sind Tunnelübergangsstrukturen bekannt.

Es ist eine Aufgabe, einen kompakten Strahlungsempfänger mit verbesserten Eigenschaften anzugeben, der auf einfache Weise herstellbar ist. Weiterhin soll ein Verfahren zur Herstellung eines solchen Strahlungsempfängers angegeben werden.

Diese Aufgaben werden durch die Gegenstände der unabhängigen Patentansprüche gelöst. Vorteilhafte Ausgestaltungen und Weiterbildungen sind Gegenstand der abhängigen Patentansprüche.

Gemäß einer Ausführungsform umfasst der Strahlungsempfänger einen Halbleiterkörper, der einen ersten aktiven Bereich und einen zweiten aktiven Bereich aufweist. Der erste aktive Bereich und der zweite aktive Bereich sind jeweils zur Detektion von Strahlung vorgesehen. Der erste aktive Bereich und der zweite aktive Bereich sind in vertikaler Richtung voneinander beabstandet. In vertikaler Richtung zwischen dem ersten aktiven Bereich und dem zweiten aktiven Bereich ist ein Tunnelbereich angeordnet. Der Tunnelbereich ist mit einer Anschlussfläche elektrisch leitend verbunden, die für eine externe elektrische Kontaktierung des Halbleiterkörpers zwischen dem ersten aktiven Bereich und dem zweiten aktiven Bereich vorgesehen ist. Gemäß der Ausführungsform ist die Anschlussfläche auf dem Tunnelbereich angeordnet.

Der Halbleiterkörper stellt also zwei aktive Bereiche zur Verfügung, in denen im Betrieb des Strahlungsempfängers, etwa durch Erzeugung und nachfolgender Trennung von Elektron-LochPaaren beim Auftreffen von elektromagnetischer Strahlung, jeweils ein Signal erzeugt werden kann. Mittels der Anschlussfläche sind die Signale zwischen den aktiven Bereichen extern abgreifbar.

Mittels des Tunnelbereichs wird eine elektrisch leitende Verbindung zwischen der Anschlussfläche und den aktiven Bereichen in einfacher Weise ausgebildet. Insbesondere kann die Anschlussfläche mit dem ersten aktiven Bereich und mit dem zweiten aktiven Bereich elektrisch leitend verbunden sein. Die Anschlussfläche kann so eine gemeinsame Anschlussfläche für den ersten aktiven Bereich und für den zweiten aktiven Bereich darstellen. Zwischen den aktiven Bereichen kann somit auf jeweils separate Anschlussflächen für die aktiven Bereiche verzichtet werden. Die Herstellung des Strahlungsempfängers wird so vereinfacht, was zu verringerten Herstellungskosten und einem geringeren Fehlprozessierungsrisiko führt.

Der Strahlungsempfänger kann auch mehr als zwei aktive Bereiche aufweisen, die insbesondere monolithisch in den Halbleiterkörper integriert ausgebildet sein können. Insbesondere kann der Halbleiterkörper auf der dem ersten aktiven Bereich abgewandten Seite des zweiten aktiven Bereichs einen dritten aktiven Bereich aufweisen. Zwischen dem zweiten aktiven Bereich und dem dritten aktiven Bereich kann ein weiterer Tunnelbereich angeordnet sein. Der weitere Tunnelbereich kann mit einer weiteren Anschlussfläche elektrisch leitend verbunden sein.

Mit anderen Worten kann also zwischen jeweils zwei benachbarten aktiven Bereichen jeweils ein Tunnelbereich angeordnet sein, der weiterhin jeweils mit einer Anschlussfläche elektrisch leitend verbunden sein kann. Auf diese Weise ist der Halbleiterkörper jeweils zwischen zwei benachbarten aktiven Bereichen extern elektrisch kontaktierbar.

Der Tunnelbereich und gegebenenfalls der weitere Tunnelbereich weisen jeweils zumindest zwei Tunnelschichten mit voneinander verschiedenen Leitungstypen auf. Somit kann eine Tunnelschicht des Tunnelbereichs beziehungsweise des weiteren Tunnelbereichs n-leitend dotiert und eine weitere Tunnelschicht des Tunnelbereichs beziehungsweise des weiteren Tunnelbereichs p-leitend dotiert ausgeführt sein. Die Tunnelschichten können jeweils hochdotiert ausgeführt sein und insbesondere eine Dotierkonzentration von mindestens 1 * 10¹⁹ cm⁻³, weitergehend von mindestens 1 * 10²⁰ cm⁻³ aufweisen. Das Herstellen einer elektrisch leitenden Verbindung mit der außerhalb des Halbleiterkörpers angeordneten Anschlussfläche beziehungsweise weiteren Anschlussfläche wird so vereinfacht.

Die der Anschlussfläche zugewandte Tunnelschicht des Tunnelbereichs kann denselben Leitungstyp aufweisen wie die der weiteren Anschlussfläche zugewandte Tunnelschicht des weiteren Tunnelbereichs. So können die Anschlussfläche und die weitere Anschlussfläche gleichartig, insbesondere hinsichtlich eines geringen Kontaktwiderstands zum Halbleiterkörper, ausgeführt sein.

Weiterhin sind die Anschlussfläche und die weitere Anschlussfläche in einem gemeinsamen Abscheideschritt herstellbar. Das Herstellungsverfahren wird so vereinfacht.

Zumindest einer der aktiven Bereiche kann zwischen einer Barriereschicht und einer Gegenbarriereschicht angeordnet sein. Insbesondere können die aktiven Bereiche jeweils zwischen einer zugeordneten Barriereschicht und einer zugeordneten Gegenbarriereschicht angeordnet sein.

Die Barriereschicht und die Gegenbarriereschicht können jeweils voneinander verschiedene Leitungstypen aufweisen. Weiterhin kann der aktive Bereich jeweils undotiert oder intrinsisch dotiert ausgeführt sein. Eine pin-Diodenstruktur ist so realisierbar.

Die Barriereschichten können denselben Leitungstyp aufweisen und den zugehörigen aktiven Bereichen jeweils vorgeordnet sein. Mit anderen Worten kann der Strahlungsempfänger eine Struktur gestapelter Dioden aufweisen, wobei die Polarität der Dioden bezüglich einer Haupteinstrahlungsrichtung jeweils gleichartig ist.

Der Halbleiterkörper kann eine Hauptstrahlungseintrittsfläche aufweisen. Durch diese Hauptstrahlungseintrittsfläche kann ein Großteil der in den aktiven Bereichen zu detektierenden Strahlung in den Halbleiterkörper eingekoppelt werden.

Die Hauptstrahlungseintrittsfläche des Halbleiterkörpers kann den Halbleiterkörper in einer vertikalen Richtung, also in einer senkrecht zu einer Haupterstreckungsebene der Halbleiterschichten des Halbleiterkörpers verlaufenden Richtung, begrenzen.

Die Hauptstrahlungseintrittsfläche des Halbleiterkörpers kann weiterhin stufenförmig ausgebildet sein. Die Hauptstrahlungseintrittsfläche kann also eine Mehrzahl von Stufenflächen aufweisen. Im Zweifel wird unter einer Stufenfläche eine sich in lateraler Richtung, also in einer Haupterstreckungsebene der Halbleiterschichten des Halbleiterkörpers verlaufenden Richtung, erstreckende Fläche verstanden. Weiterhin kann eine Stufenfläche in lateraler Richtung durch zumindest eine schräg oder senkrecht zur Haupterstreckungsebene stehende Seitenfläche begrenzt sein.

Insbesondere kann jedem aktiven Bereich eine Stufenfläche zugeordnet sein. Die in den jeweiligen aktiven Bereich zu detektierende Strahlung kann somit überwiegend durch die jeweils zugeordnete Stufenfläche in den Halbleiterkörper eingekoppelt werden. Die in den aktiven Bereichen jeweils zu detektierende Strahlung kann so auf den jeweiligen aktiven Bereich treffen, ohne zuvor einen der vorgeordneten aktiven Bereiche durchlaufen zu haben.

Mit anderen Worten strahlt die in dem jeweiligen aktiven Bereich zu empfangende Strahlung überwiegend durch die diesem aktiven Bereich zugeordnete Stufenfläche der Hauptstrahlungseintrittsfläche hindurch in diesen aktiven Bereich ein. Die aktiven Bereiche können so weitgehend unabhängig von den anderen, diesen vorgeordneten aktiven Bereichen konzipiert werden.

Weiterhin können die Verhältnisse der in den aktiven Bereichen erzeugten Signale zueinander weitgehend unabhängig von der Grundfläche der aktiven Bereiche über die relativen Flächenanteile der zugeordneten Stufenflächen eingestellt werden. Insbesondere können so zwei aktive Bereiche mit voneinander verschiedener Grundfläche Signale in vergleichbarer Höhe erzeugen.

Eine Haupteinstrahlungseintrittsfläche eines Halbleiterkörpers wird dagegen im Rahmen der Anmeldung nicht als stufenförmig ausgebildet angesehen, wenn diese lediglich zur Kontaktierung vergrabener Halbleiterschichten vorgesehene Vertiefungen aufweist und im Bereich der Vertiefungen verglichen mit der gesamten Haupteinstrahlungsfläche jeweils nur ein kleiner Strahlungsanteil, etwa 10% oder weniger, in den Halbleiterkörper eingekoppelt wird.

In vertikaler Richtung kann jeweils zwischen zwei benachbarten aktiven Bereichen eine Stufenfläche ausgebildet sein. Die Zuordnung der Stufenflächen zu den zugehörigen aktiven Bereichen wird so vereinfacht.

Bei einer Stufenfläche, die zwischen zwei aktiven Bereichen angeordnet ist, kann der Tunnelbereich zumindest bereichsweise entfernt sein. Eine Absorption der in dem dem Tunnelbereich nachgeordneten aktiven Bereich zu detektierenden Strahlung kann im Bereich der Stufenfläche vermieden werden.

In einer Ausgestaltungsvariante sind zumindest zwei Stufenflächen in Aufsicht flächig nebeneinander angeordnet. Insbesondere können die Stufenflächen so ausgebildet sein, dass eine Verbindungslinie zwischen zwei beliebigen Punkten einer Stufenfläche in Aufsicht nicht durch eine andere Stufenfläche hindurch verläuft. Beispielsweise können die Stufenflächen jeweils eine mehreckige, etwa dreieckige oder viereckige, Grundform aufweisen. Die Stufenflächen können in ihrer Formgebung so ausgeführt sein, dass die Stufenflächen bei einer vorgegebenen Fläche eine möglichst geringe Gesamtlänge der Umrandungen aufweisen. Die Gefahr, dass entlang der Umrandung auftretende Leckströme die Empfindlichkeit des Strahlungsempfängers beeinträchtigen, kann so minimiert werden.

In einer alternativen Ausgestaltung greifen zumindest zwei Stufenflächen in Aufsicht auf den Halbleiterkörper bereichsweise ineinander. Beispielsweise kann eine der Stufenflächen kammartig ausgeführt sein, wobei in den Zwischenräumen zumindest bereichsweise eine andere Stufenfläche verläuft. Mittels einer solchen Anordnung können die Stufenflächen vergleichsweise homogen über die Grundfläche des Strahlungsempfängers verteilt sein. So sind auch bei räumlich inhomogener Bestrahlung des Strahlungsempfängers die spektralen Anteile der auftreffenden Strahlung und insbesondere deren Verhältnis zueinander zuverlässig ermittelbar.

Der erste aktive Bereich kann dem zweiten aktiven Bereich vorgeordnet sein. Der Begriff "vorgeordnet" bezieht sich im Rahmen der Anmeldung jeweils auf die relative Anordnung entlang einer Hauptrichtung des Strahlungseintritts. Hierbei impliziert der Begriff "vorgeordnet" bezogen auf die auftreffende Strahlung jedoch nicht, dass auf ein Element des Strahlungsempfängers treffende Strahlung zunächst ein diesem Element vorgeordnetes Element durchlaufen muss. Beispielsweise kann auf den zweiten aktiven Bereich auftreffende Strahlung durch die diesem aktiven Bereich zugeordnete Stufenfläche hindurch treten, ohne den vorgeordneten ersten aktiven Bereich zu durchlaufen.

Die dem ersten aktiven Bereich zugeordnete Stufenfläche kann weiterhin zusammenhängend ausgebildet sein. Eine externe elektrische Kontaktierung des ersten aktiven Bereichs ist so vereinfacht.

Weiterhin kann die dem zweiten aktiven Bereich zugeordnete Stufenfläche die dem ersten aktiven Bereich zugeordnete Stufenfläche zumindest bereichsweise umlaufen. Eine mittels der dem ersten aktiven Bereich zugeordneten Stufenfläche und der dem zweiten aktiven Bereich zugeordnete Stufenfläche gebildete Fläche kann so vereinfacht zusammenhängend ausgebildet sein. Eine externe elektrische Kontaktierung des zweiten aktiven Bereichs, insbesondere mittels der Anschlussfläche, wird dadurch vereinfacht.

Insbesondere bei einem Tunnelbereich, der für die in dem nachgeordneten aktiven Bereich oder in den nachgeordneten aktiven Bereichen zu detektierenden Strahlung eine hinreichende Transparenz aufweist, kann auf das Ausbilden einer Stufenfläche auch verzichtet werden. Die Strahlung kann für alle aktiven Bereiche durch eine gemeinsame, insbesondere nicht segmentierte, Hauptstrahlungseintrittsfläche hindurchtreten. Bevor die Strahlung auf einen aktiven Bereich auftrifft, durchläuft diese also in diesem Fall den anderen oder die anderen diesem aktiven Bereich vorgeordneten aktiven Bereiche.

Weiterhin kann zumindest einer der aktiven Bereiche im sichtbaren Spektralbereich empfindlich sein. Insbesondere können die aktiven Bereiche jeweils bei einer Peak-Wellenlänge ein Detektionsmaximum aufweisen, wobei zumindest eine Peak-Wellenlänge im sichtbaren Spektralbereich liegt. Die Peak-Wellenlängen können voneinander beabstandet sein. Beispielsweise kann der Strahlungsempfänger drei aktive Bereiche aufweisen, die eine Peak-Wellenlänge im roten, grünen und blauen Spektralbereich aufweisen.

Mittels eines solchen Strahlungsempfängers kann vereinfacht ein Farbsensor realisiert werden, der für die drei Grundfarben Rot, Grün und Blau jeweils ein Signal erzeugt. Mittels eines solchen Farbsensors kann beispielsweise die Abstrahlung einer vollfarbigen Anzeigevorrichtung überwacht werden. Der Farbsensor kann insbesondere zur Anpassung der relativen Intensitäten der abgestrahlten Strahlung an einen vorgegebenen Wert, insbesondere für einen Weißabgleich, vorgesehen sein.

Weiterhin kann zumindest einer der Strahlungsempfänger spektral schmalbandig ausgeführt sein. Je weniger die spektralen Detektionsbereiche der aktiven Bereiche überlappen, desto besser können voneinander getrennte Farbsignale erzeugt werden.

Insbesondere kann ein Abstand zwischen den Peak-Wellenlängen zweier benachbarter Detektionsmaxima größer sein als die Summe der diesen Detektionsmaxima jeweils zugeordneten Halbwertsbreiten. Unter der Halbwertsbreite wird die halbe spektrale Breite auf Höhe der Hälfte des Maximalwerts (half width at half maximum, HWHM) verstanden.

Weiterhin können die Peak-Wellenlängen entlang der Hauptrichtung des Strahlungseintritts zunehmen. Beispielsweise können entlang der Hauptrichtung des Strahlungseintritts gesehen die aktiven Bereiche Peak-Wellenlängen im blauen, im grünen und im roten Spektralbereich aufweisen.

Davon abweichend kann entlang der Hauptrichtung des Strahlungseintritts zumindest ein aktiver Bereich eine kleinere Peak-Wellenlänge aufweisen als ein vorgeordneter aktiver Bereich. Der vorgeordnete aktive Bereich kann also für die Strahlung mit der kleineren Peak-Wellenlänge absorbierend ausgebildet sein. Die im nachgeordneten aktiven Bereich zu empfangende Strahlung kann durch die diesem aktiven Bereich zugeordnete Stufenfläche eingekoppelt werden. Die Reihenfolge der aktiven Bereiche in vertikaler Richtung kann also unabhängig von deren Peak-Wellenlänge gewählt werden. Bei der Abscheidung des Halbleiterkörpers kann die Reihenfolge der aktiven Bereiche also hinsichtlich anderer Kriterien, etwa der Gitterparameter der jeweils für die aktiven Bereiche verwendeten Halbleitermaterialien, optimiert werden.

Weiterhin kann zumindest einem der aktiven Bereiche ein passiver Bereich vorgeordnet sein. Insbesondere kann der passive Bereich zur Formung einer kurzwelligen Flanke eines spektralen Detektionsbereichs des zugeordneten aktiven Bereichs vorgesehen sein. Unter einem passiven Bereich wird ein Bereich verstanden, in dem darin absorbierte Strahlung keinen Beitrag zum Signal des zugehörigen aktiven Bereichs liefert. Ein passiver Bereich kann beispielsweise mittels einer dotierten Halbleiterschicht gebildet sein, wobei jedoch beim Strahlungsauftritt erzeugte Elektron-Loch-Paare nicht voneinander getrennt werden und nachfolgend wieder rekombinieren.

Insbesondere kann der passive Bereich eine Halbleiterschicht aufweisen, deren Bandlücke größer ist als eine Bandlücke einer Halbleiterschicht des zugeordneten aktiven Bereichs. Auf diese Weise kann die kurzwellige Flanke des Detektionsbereichs des aktiven Bereichs auf einfache Weise geformt werden. Ein spektraler Überlapp zwischen zwei Detektionsbereichen kann so vermindert werden.

Zumindest einer der aktiven Bereiche kann ein III-V-Verbindungshalbleitermaterial enthalten. III-V-Verbindungshalbleitermaterialien können eine hohe Absorptionseffizienz aufweisen.

Für eine Detektion im sichtbaren Spektralbereich eignet sich insbesondere ein auf Phosphid-Verbindungshalbleitern basierendes Material.

"Auf Phosphid-Verbindungshalbleitern basierend" bedeutet in diesem Zusammenhang, dass eine Halbleiterschicht einen phosphorhaltigen Verbindungshalbleiter, insbesondere AlₙGaₘIn₁₋ₙ₋ₘP umfasst, wobei 0 ≤ n ≤ 1, 0 ≤ m ≤ 1 und n+m ≤ 1 gilt. Hierbei kann auch n ≠ 0 und/oder m ≠ 0 gelten. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Ein auf Phosphid-Verbindungshalbleitern basierender aktiver Bereich kann sich durch eine hohe Absorptionseffizienz im sichtbaren Spektralbereich auszeichnen, wobei gleichzeitig die Empfindlichkeit im infraroten Spektralbereich gering sein kann. Auf zusätzliche, externe Filter zum Blocken von Infrarotstrahlung kann somit verzichtet werden. Der Strahlungsempfänger kann demnach besonders kompakt ausgestaltet sein.

Die aktiven Bereiche können bezüglich der Materialzusammensetzung voneinander verschieden sein. Insbesondere können die aktiven Bereiche voneinander verschiedene Bandlücken aufweisen. Solche aktive Bereiche zeigen intrinsisch ein voneinander verschiedenes Absorptionsverhalten. Im Unterschied zu einem spektral breitbandigen Strahlungsempfänger, etwa einem Silizium-Detektor, kann daher auf separate Filterschichten zur Selektion einzelner Spektralbereiche verzichtet werden. Durch geeignete Wahl der Materialzusammensetzung des Halbleiterkörpers sind also vereinfacht aktive Bereiche erzeugbar, deren spektrale Empfindlichkeit überwiegend jeweils in einem vorgegebenen Bereich liegt.

Der Strahlungsempfänger kann insbesondere zum Betrieb in einem Farbsensor vorgesehen sein. Unter einem Farbsensor wird allgemein ein Sensor verstanden, der für zumindest zwei voneinander verschiedene Spektralbereiche jeweils ein Signal liefert. Die Spektralbereiche müssen nicht notwendigerweise im sichtbaren Spektralbereich liegen.

Der Farbsensor kann eine Mehrzahl von Farbkanälen, etwa drei Farbkanäle oder mehr, aufweisen. Das an den Anschlussflächen des Strahlungsempfängers abgreifbare Signal kann einer Auswerteschaltung des Farbsensors zugeführt werden.

In einer Ausgestaltungsvariante ist für jeden Farbkanal jeweils ein aktiver Bereich des Strahlungsempfängers einzeln kontaktiert. Die Signale der aktiven Bereiche können unabhängig voneinander, etwa parallel oder zeitlich nacheinander, abgegriffen werden.

In einer alternativen Ausgestaltungsvariante können die aktiven Bereiche des Strahlungsempfängers bezüglich einer gemeinsamen Anschlussfläche als Referenzkontakt, etwa bezüglich einer oberen Anschlussfläche oder einer unteren Anschlussfläche, kontaktiert sein. Die aktiven Bereiche können mittels der Tunnelbereiche zueinander in Serie verschaltet sein. Die Signale für die einzelnen Farbkanäle können insbesondere mittels einer arithmetischen Operation, etwa einer Subtraktion, aus den an den Anschlussflächen abgreifbaren Signalen erzeugt werden.

Bei einem Verfahren zur Herstellung eines Strahlungsempfängers wird gemäß einer Ausführungsform ein Halbleiterkörper bereitgestellt. Der Halbleiterkörper weist einen ersten aktiven Bereich und einen zweiten aktiven Bereich auf, wobei die aktiven Bereiche jeweils zur Detektion von Strahlung vorgesehen sind und wobei zwischen dem ersten aktiven Bereich und dem zweiten aktiven Bereich ein Tunnelbereich angeordnet ist. Der Tunnelbereich wird freigelegt, wobei der erste aktive Bereich bereichsweise entfernt wird. Auf dem freigelegten Tunnelbereich wird eine Anschlussfläche ausgebildet.

Auf diese Weise kann vereinfacht ein Halbleiterkörper hergestellt werden, der über die Anschlussfläche zwischen dem ersten aktiven Bereich und dem zweiten aktiven Bereich kontaktiert werden kann.

Der Halbleiterkörper kann epitaktisch, beispielsweise mittels MOCVD oder MBE auf einem Aufwachssubstrat abgeschieden werden. Während der Herstellung kann das Aufwachssubstrat gedünnt oder entfernt werden. Dies kann jeweils vollflächig oder zumindest bereichsweise erfolgen.

Weiterhin kann das Freilegen des Tunnelbereichs mittels nasschemischen Ätzens durchgeführt werden. Der Tunnelbereich kann als Ätzstopp dienen. Mit anderen Worten kann das Freilegen mittels materialselektiven nasschemischen Ätzens erfolgen. Hierfür ist der Tunnelbereich insbesondere mittels einer Materialgruppe gebildet sein, die bezüglich des Ätzverhaltens von dem für die aktiven Bereiche verwendeten Material verschieden ist. Insbesondere können der Tunnelbereich und die aktiven Bereiche auf Materialien basieren, die voneinander verschiedene Gruppe-V-Materialien enthalten. Beispielsweise kann zumindest einer der aktiven Bereiche, insbesondere können alle aktiven Bereiche, auf einem Phosphid-Verbindungshalbleitermaterial basieren. Der Tunnelbereich und gegebenenfalls weitere Tunnelbereiche können auf einem Arsenid-Verbindungshalbleitermaterial basieren.

Eine auf Arsenid-Verbindungshalbleitern basierende Halbleiterschicht enthält einen Arsenhaltigen Verbindungshalbleiter, insbesondere aus dem Materialsystem AlₙGaₘIn₁₋ₙ₋ₘAS, wobei 0 ≤ n ≤ 1, 0 ≤ m ≤ 1 und n+m ≤ 1 gilt. Hierbei kann auch n ≠ 0 und/oder m ≠ 0 gelten. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Der Halbleiterkörper kann auf der dem ersten aktiven Bereich abgewandten Seite des zweiten aktiven Bereichs einen dritten aktiven Bereich aufweisen. Zwischen dem zweiten aktiven Bereich und dem dritten aktiven Bereich kann ein weiterer Tunnelbereich angeordnet sein. Auf dem Tunnelbereich und dem weiteren Tunnelbereich können in einem gemeinsamen Abscheideschritt jeweils eine Anschlussfläche abgeschieden werden. Die Herstellung des Strahlungsempfängers wird so vereinfacht.

Das Abscheiden einer außerhalb des Halbleiterkörpers angeordneten Anschlussfläche kann beispielsweise mittels Aufsputterns oder Aufdampfens erfolgen.

Das beschriebene Verfahren ist zur Herstellung eines weiter oben beschriebenen Strahlungsempfängers besonders geeignet. Im Zusammenhang mit dem Verfahren beschriebene Merkmale können daher auch für den Strahlungsempfänger herangezogen werden und umgekehrt. Weitere Merkmale, Ausgestaltungen und Zweckmäßigkeiten ergeben sich aus der folgenden Beschreibung der Ausführungsbeispiele in Verbindung mit den Figuren.

Es zeigen:
- Figur 1: ein erstes Ausführungsbeispiel für einen Strahlungsempfänger in schematischer Schnittansicht,
- Figur 2: die Responsivitäten der aktiven Bereiche jeweils als Funktion der Wellenlänge der auftreffenden Strahlung für einen Strahlungsempfänger gemäß dem ersten Ausführungsbeispiel,
- Figur 3: ein zweites Ausführungsbeispiel für einen Strahlungsempfänger in schematischer Aufsicht,
- die Figuren 4A und 4B: ein drittes Ausführungsbeispiel für einen Strahlungsempfänger in schematischer Aufsicht (Figur 4A) und zugehöriger schematischer Schnittansicht (Figur 4B),
- die Figuren 5A und 5B: ein erstes beziehungsweise zweites Ausführungsbeispiel für einen Farbsensor in jeweils schematischer Darstellung, und
- die Figuren 6A bis 6F: ein erstes Ausführungsbeispiel für ein Verfahren zur Herstellung eines Strahlungsempfängers anhand von schematisch in Schnittansicht dargestellten Zwischenschritten.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

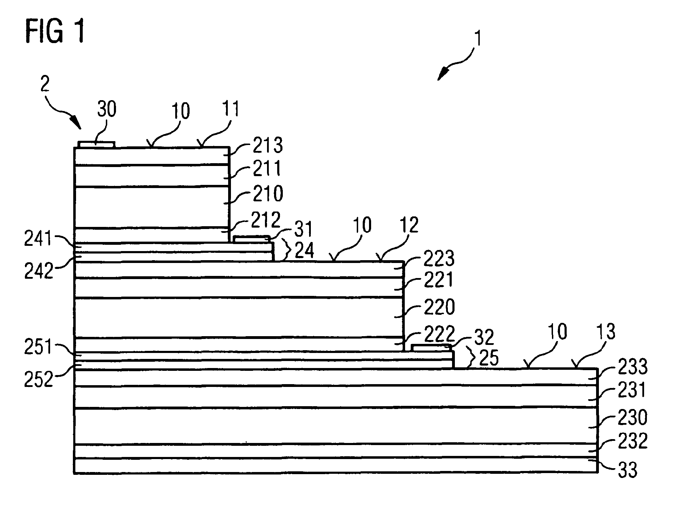

In Figur 1 ist ein erstes Ausführungsbeispiel für einen Strahlungsempfänger 1 dargestellt, der einen Halbleiterkörper 2 aufweist. Der Halbleiterkörper 2 umfasst einen ersten aktiven Bereich 210, einen zweiten aktiven Bereich 220 und einen dritten aktiven Bereich 230. Der dritte aktive Bereich ist auf der dem ersten aktiven Bereich abgewandten Seite des zweiten aktiven Bereichs angeordnet.

In Aufsicht auf den Halbleiterkörper überlappen die aktiven Bereiche teilweise. Der erste aktive Bereich 210 bedeckt den zweiten aktiven Bereich 220 nur bereichsweise. Weiterhin bedeckt der zweite aktive Bereich 220 den dritten aktiven Bereich 230 nur bereichsweise.

Entlang einer Hauptrichtung des Strahlungseintritts ist der erste aktive Bereich 210 dem zweiten aktiven Bereich 220 vorgeordnet. Weiterhin ist der zweite aktive Bereich 220 dem dritten aktiven Bereich 230 entlang dieser Richtung vorgeordnet.

Zwischen zwei benachbarten aktiven Bereichen, also zwischen dem ersten aktiven Bereich 210 und dem zweiten aktiven Bereich 220 sowie zwischen dem zweiten aktiven Bereich 220 und dem dritten aktiven Bereich 230 ist ein Tunnelbereich 24 beziehungsweise ein weiterer Tunnelbereich 25 angeordnet.

Der Tunnelbereich 24 ragt in lateraler Richtung zumindest bereichsweise über den aktiven Bereich 210 hinaus. Auf dem Tunnelbereich 24 und dem weiteren Tunnelbereich 25 ist eine Anschlussfläche 31 beziehungsweise eine weitere Anschlussfläche 32 angeordnet. Die Anschlussfläche und die weitere Anschlussfläche sind für die externe elektrische Kontaktierung des Halbleiterkörpers 2 zwischen den jeweiligen aktiven Bereichen vorgesehen, zwischen denen die Tunnelbereiche angeordnet sind.

Die Anschlussflächen sind zweckmäßigerweise elektrisch leitend ausgebildet und können ein Metall, etwa Au, Ti, Ni, Pt, Ag, Rh oder Al, oder eine metallische Legierung, insbesondere mit zumindest einem der genannten Metalle, enthalten oder aus einem solchen Metall oder einer solchen metallischen Legierung bestehen. Weiterhin können die Anschlussflächen auch mehrschichtig ausgebildet sein.

Auf der dem Tunnelbereich 24 abgewandten Seite des ersten aktiven Bereichs 210 ist eine obere Anschlussfläche 30 angeordnet. Weiterhin ist auf der dem zweiten aktiven Bereich 220 abgewandten Seite des dritten aktiven Bereichs 230 eine untere Anschlussfläche 33 angeordnet. Somit weist jeder aktiver Bereich auf beiden Seiten jeweils eine Anschlussfläche auf, wodurch ein in dem aktiven Bereich im Betrieb des Strahlungsempfängers 1 erzeugtes Signal von außen jeweils von beiden Seiten des aktiven Bereichs zugänglich ist.

Der Halbleiterkörper 2 weist eine Hauptstrahlungseintrittsfläche 10 auf, die stufenartig ausgebildet ist. Jedem aktiven Bereich ist eine Stufenfläche zugeordnet, über die die in dem jeweiligen aktiven Bereich zu empfangende Strahlung in den Halbleiterkörper 2 eingekoppelt wird. Die Stufenflächen erstrecken sich jeweils in lateraler Richtung und verlaufen parallel zueinander.

Dem ersten aktiven Bereich 210 ist eine erste Stufenfläche 11, dem zweiten aktiven Bereich 220 eine zweite Stufenfläche 12 und dem dritten aktiven Bereich 230 eine dritte Stufenfläche 13 zugeordnet. In vertikaler Richtung, also in einer senkrecht zu einer Haupterstreckungsebene der Halbleiterschichten des Halbleiterkörpers 2 verlaufenden Richtung sind die Stufenflächen jeweils versetzt zueinander angeordnet. In lateraler Richtung verlaufen die Stufenflächen überlappungsfrei.

Zwischen zwei benachbarten aktiven Bereichen ist jeweils eine Stufenfläche ausgebildet. Auf diese Weise kann beispielsweise die im dritten aktiven Bereich 230 zu empfangende Strahlung über die Stufenfläche 13 eingekoppelt werden und muss somit nicht die vorgeordneten aktiven Bereiche 210 und 220 durchlaufen. Die aktiven Bereiche des Halbleiterkörpers 2 können so weitgehend unabhängig voneinander an eine jeweils diesem aktiven Bereich vorgegebene spektrale Empfindlichkeitscharakteristik angepasst werden. Die spektrale Empfindlichkeit der aktiven Bereiche ist somit unabhängig oder zumindest weitgehend unabhängig von gegebenenfalls dem jeweiligen aktiven Bereich vorgeordneten weiteren aktiven Bereichen.

Über den Flächenanteil der jeweiligen Stufenflächen 11, 12, 13 an der gesamten Hauptstrahlungseintrittsfläche 10 können die Empfindlichkeiten der einzelnen aktiven Bereiche 210, 220, 230 aufeinander abgestimmt und insbesondere aneinander angepasst werden.

Die aktiven Bereiche 210, 220, 230 sind jeweils zwischen einer Barriereschicht 211, 221, 231 und einer Gegenbarriereschicht 212, 222, 232 angeordnet, wobei die Barriereschichten jeweils den zugeordneten aktiven Bereichen vorgeordnet sind.

Die aktiven Bereiche 210, 220, 230 können intrinsisch oder undotiert ausgebildet sein. In den aktiven Bereichen erzeugte Elektron-Loch-Paare können so voneinander getrennt werden und über die jeweiligen Barriereschichten beziehungsweise Gegenbarriereschichten zu den jeweiligen Anschlussflächen 30, 31, 32, 33 gelangen.

Die Barriereschichten sind jeweils p-leitend und die Gegenbarriereschichten jeweils n-leitend dotiert. Der Strahlungsempfänger kann so gemäß übereinander gestapelten, monolithisch integrierten, pin-Dioden ausgebildet sein, wobei jede Diode über die Anschlussflächen beidseits des aktiven Bereichs extern elektrisch kontaktierbar ist.

Der Tunnelbereich 24 und der weitere Tunnelbereich 25 umfassen jeweils eine erste Tunnelschicht 241 beziehungsweise eine erste weitere Tunnelschicht 251 und eine zweite Tunnelschicht 242 beziehungsweise eine zweite weitere Tunnelschicht 252, die voneinander verschiedene Leitungstypen aufweisen. Die erste Tunnelschicht 241 beziehungsweise 251 weist jeweils dieselbe Dotierung auf wie die dieser am nächsten gelegenen Gegenbarriereschicht 212 beziehungsweise 222 und die zweite Tunnelschicht 242, 252 dieselbe Dotierung wie die dieser am nächsten gelegenen Barriereschicht 221, 231.

Ladungsträger können so vereinfacht von beiden Seiten des Tunnelbereichs 24 beziehungsweise des weiteren Tunnelbereichs 25 zu der Anschlussfläche 31 beziehungsweise zu der weiteren Anschlussfläche 32 gelangen.

Mittels der Tunnelbereiche 24, 25 sind die Signale von drei aktiven Bereichen über insgesamt vier Anschlussflächen extern zugänglich. Über den Tunnelbereich 24 können beispielsweise sowohl Ladungsträger aus dem ersten Bereich 210, insbesondere durch die Gegenbarriereschicht 212 hindurch, als auch Ladungsträger aus dem zweiten aktiven Bereich 220, insbesondere durch die Barriere 222 hindurch, zur Anschlussfläche 31 gelangen und dort abgegriffen werden. Zwischen zwei aktiven Bereichen sind also separate Anschlussflächen für die Barriereschicht und für die Gegenbarriereschicht nicht erforderlich. Auf ein separates Freilegen der Barriereschicht und der Gegenbarriereschicht, etwa durch zwei separate Ätzschritte mit unterschiedlichen Ätztiefen, kann folglich verzichtet werden. Insbesondere kann dadurch die Anzahl der erforderlichen Ätzschritte verringert werden.

Durch die Tunnelbereiche 24, 25 kann also sowohl die Anzahl der Anschlussflächen als auch die Zahl der Ätzschritte verringert werden. Die Herstellung des Strahlungsempfängers 1 wird dadurch vereinfacht und somit das Risiko einer Fehlproduktion verringert. Weiterhin wird der Anteil der Oberfläche des Strahlungsempfängers, der durch Anschlussflächen abgeschattet ist, vermindert. Die Strahlung kann so verbessert in den Strahlungsempfänger eingekoppelt werden.

Die Tunnelschichten 241, 242, 251, 252 können jeweils hochdotiert ausgeführt sein, etwa mit einer Dotierkonzentration von mindestens 1 * 10¹⁹ cm⁻³, insbesondere mindestens 1 * 10²⁰ cm⁻¹.

Aufgrund der hohen Dotierung weisen die Tunnelschichten eine vergleichsweise hohe Querleitfähigkeit auf. Somit erleichtert der Tunnelbereich, insbesondere erleichtern die Tunnelschichten, die Zufuhr der in den aktiven Bereichen durch Erzeugung von Elektron-Lochpaaren freigesetzten Ladungsträger zur Anschlussfläche 31 beziehungsweise zur weiteren Anschlussfläche 32. Die auftretenden Ströme können insbesondere im Bereich von wenigen Mikroampère liegen.

Auf zusätzliche, außerhalb des Halbleiterkörpers 2 ausgebildete Kontaktfingerstrukturen, kann somit verzichtet werden. Die Herstellung des Strahlungsempfängers wird so vereinfacht. Gegebenenfalls können solche Kontaktfingerstrukturen aber zusätzlich vorgesehen sein.

Die erste Tunnelschicht 241 des Tunnelbereichs 24 und die erste Tunnelschicht 251 des weiteren Tunnelbereichs 25 weisen denselben Leitungstyp auf. Eine Ohmsche Verbindung zu den jeweiligen Anschlussflächen 31 beziehungsweise 32 kann so bei gleichartig ausgebildeten Anschlussflächen erzielt werden. Die externe elektrische Kontaktierung des Halbleiterkörpers 2 zwischen den aktiven Bereichen wird so vereinfacht.

Den aktiven Bereichen 210, 220, 230 ist jeweils ein passiver Bereich, also ein erster passiver Bereich 213, ein zweiter passiver Bereich 223 beziehungsweise ein dritter passiver Bereich 233 vorgeordnet. Die passiven Bereiche 213, 223, 233 weisen jeweils dieselbe Dotierung auf wie die daran angrenzende Barriereschicht 211, 221 beziehungsweise 231.

Im Unterschied zu den aktiven Bereichen 210, 220, 230 führt eine Absorption in den passiven Bereichen nicht zur Erzeugung eines Signals. Die passiven Bereiche erfüllen also jeweils die Funktion einer monolithisch in den Halbleiterkörper integrierten Filterschicht. Über die gezielte Absorption in den passiven Bereichen kann für den jeweils zugeordneten aktiven Bereich die spektrale Empfindlichkeit eingestellt werden. Eine spektrale Trennung der Detektionsbereiche der aktiven Bereiche ist so vereinfacht.

Von dem dargestellten Ausführungsbeispiel abweichend kann auf die passiven Schichten auch verzichtet werden.

Von dem beschriebenen Ausführungsbeispiel weiterhin abweichend können Halbleiterschichten, insbesondere die Barriereschichten, die Gegenbarriereschichten, die Tunnelschichten und die passiven Bereiche bezüglich ihres Leitungstyps auch invertiert ausgebildet sein, das heißt, die n-leitend dotierten Halbleiterschichten können p-leitend dotiert sein und umgekehrt.

Weiterhin können die aktiven Bereiche auch mittels einer Raumladungszone gebildet sein, die an einem pn-Übergang auftreten kann. Eine separate, intrinsisch oder undotiert ausgeführte Schicht zwischen der jeweiligen Barriereschicht und der zugehörigen Gegenbarriereschicht ist nicht erforderlich.

Ferner kann der Strahlungsempfänger auch nur zwei aktive Bereiche oder mehr als drei aktive Bereiche aufweisen.

Weiterhin kann auf eine stufenartige Ausbildung der Hauptstrahlungseintrittsfläche auch verzichtet werden. In diesem Fall kann die Einkopplung der Strahlung in die aktiven Bereiche überwiegend über eine gemeinsame, insbesondere nicht segmentierte, Strahlungseintrittsfläche erfolgen. Gegenüber der stufenartigen Ausbildung kann somit bei gleicher Größe des Halbleiterkörpers die für jeden aktiven Bereich zur Strahlungseinkopplung nutzbare Fläche vergrößert sein. Zur Kontaktierung der aktiven Bereiche können die vorgeordneten aktiven Bereiche in nur vergleichsweise kleinen Bereichen entfernt sein, um die jeweiligen Tunnelbereiche freizulegen und auf den freigelegten Tunnelbereichen Anschlussflächen vorzusehen. Eine derartige Ausgestaltung ist insbesondere zweckmäßig, wenn die zur Detektion vorgesehene Strahlung nur zu einem hinreichend geringen Anteil in den dem jeweiligen aktiven Bereich vorgeordneten Schichten, etwa in einem vorgeordneten, anderen aktiven Bereich oder einem vorgeordneten Tunnelbereich, absorbiert wird.

Der Halbleiterkörper 2 kann von dem gezeigten Ausführungsbeispiel abweichend auf einem Träger angeordnet sein. Dieser Träger kann beispielsweise mittels eines Aufwachssubstrats für die Halbleiterschichten des Halbleiterkörpers 2 gebildet sein. Das Aufwachssubstrat kann bereichsweise entfernt oder bereichsweise entfernt oder gedünnt sein. Die untere Anschlussfläche kann auf der dem Halbleiterkörper 2 abgewandten Seite des Aufwachssubstrats angeordnet sein.

Der beschriebene Aufbau des Strahlungsempfängers ist insbesondere für einen Farbsensor besonders geeignet, der für voneinander verschiedene spektrale Detektionsbereiche jeweils ein Signal erzeugt. Die Detektionsbereiche können insbesondere im ultravioletten, im sichtbaren oder im infraroten Spektralbereich liegen.

Der Halbleiterkörper 2, insbesondere die aktiven Bereiche 210, 220, 230, können auf einem III-V-Verbindungshalbleitermaterial, basieren.

Für eine Detektion von Strahlung im sichtbaren Spektralbereich, beispielsweise eines Farbtripels, etwa im roten, grünen und blauen Spektralbereich, eignen sich insbesondere aktive Bereiche, die auf einem phosphidischen Verbindungshalbleitermaterial, insbesondere auf AlₙGaₘIn₁₋ₙ₋ₘP, basieren, wobei 0 ≤ n ≤ 1, 0 ≤ m ≤ 1 und n+m ≤ 1 gilt. Durch geeignete Wahl der Materialzusammensetzung für die aktiven Bereiche 210, 220, 230 und gegebenenfalls die zugehörigen passiven Bereiche 213, 223, 233 kann die spektrale Empfindlichkeit des Strahlungsempfängers in weiten Grenzen eingestellt werden.

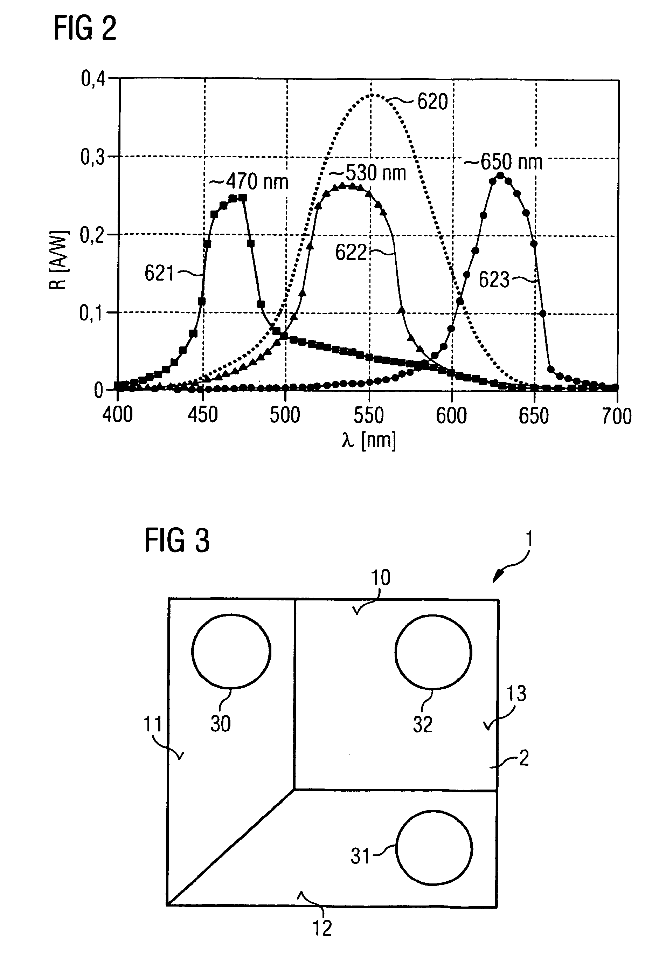

Ein Beispiel für die spektrale Empfindlichkeit eines Strahlungsempfängers, der wie im Zusammenhang mit Figur 1 beschrieben ausgeführt ist, ist in Figur 2 gezeigt. Die Kurven 621, 622 und 623 zeigen jeweils die Responsivität eines Detektors im blauen, grünen beziehungsweise roten Spektralbereich als Funktion der Vakuumwellenlänge λ der auf den Strahlungsempfänger auftreffenden Strahlung.

Zum Vergleich zeigt die Kurve 620 die spektrale Empfindlichkeitsverteilung des menschlichen Auges (V_{λ}-Kurve).

Der zur Detektion von blauer Strahlung vorgesehene erste aktive Bereich basiert auf AlInP. Dem ersten aktiven Bereich 210 ist ein passiver Bereich 213 zugeordnet, der auf GaP basiert. Die Peak-Wellenlänge des ersten aktiven Bereichs liegt bei etwa 470 nm.

Der zweite aktive Bereich 220, der zur Detektion der Strahlung im grünen Wellenlängenbereich vorgesehen ist, basiert auf AlGaInP mit einem Aluminiumgehalt von n = 0,5. Diesem aktiven Bereich ist ein passiver Bereich 223 vorgeordnet, der auf AlGaInP mit einem Aluminiumgehalt von n = 0,80 basiert. Die Peak-Wellenlänge des zweiten aktiven Bereichs liegt bei etwa 530 nm.

Der für die Detektion von roter Strahlung vorgesehene dritte aktive Bereich 230 basiert auf GaInP. Der zugehörige passive Bereich 233 basiert auf AlGaInP mit einem Aluminiumgehalt von n = 0,30. Die Peak-Wellenlänge des dritten aktiven Bereichs liegt bei etwa 640 nm.

Die passiven Bereiche weisen jeweils eine Bandlücke auf, die größer ist als die Bandlücke des aktiven Bereichs, dem sie jeweils zugeordnet sind. Die kurzwellige Flanke des jeweiligen Responsivitätsspektrums kann so gezielt durch Absorption der kürzerwelligen Strahlung in dem zugeordneten passiven Bereich eingestellt werden.

Weiterhin zeigt die Figur 2, dass die spektralen Detektionsbereiche der aktiven Bereiche 210, 220, 230 einen nur vergleichsweise geringen Überlapp aufweisen. Die spektralen Detektionsbereiche sind jeweils derart schmalbandig ausgeführt, dass der spektrale Abstand zwischen zwei benachbarten Peak-Wellenlängen größer ist als die Summe der Halbwertsbreiten der diesen Detektionsbereichen zugeordneten Halbwertsbreite.

Von dem beschriebenen Ausführungsbeispiel abweichend müssen die Peak-Wellenlängen der aktiven Bereiche nicht notwendigerweise entlang der Hauptrichtung des Strahlungseintritts zunehmen. Vielmehr kann zumindest einem aktiven Bereich ein anderer aktiver Bereich mit einer größeren Peak-Wellenlänge vorgeordnet sein.

Die Tunnelbereiche 24, 25 können hierbei auf AlₓGa₁₋ₓAs mit 0 = x = 1 basieren. Die Materialzusammensetzung aller oder zumindest einiger phosphidischen Halbleiterschichten kann so gewählt sein, dass diese gitterangepasst oder zumindest weitgehend gitterangepasst zu den arsenidischen Tunnelbereichen sind. Hierfür können die phosphidischen Halbleiterschichten einen Indium-Gehalt von etwa 50% aufweisen.

In Figur 3 ist ein zweites Ausführungsbeispiel für einen Strahlungsempfänger 1 in schematischer Aufsicht dargestellt. In vertikaler Richtung kann der Strahlungsempfänger wie in Zusammenhang mit Figur 1 beschrieben ausgeführt sein.

Die Hauptstrahlungseintrittsfläche 10 ist stufenartig ausgebildet und weist eine erste Stufenfläche 11, eine zweite Stufenfläche 12 und eine dritte Stufenfläche 13 auf. Durch die Stufenflächen hindurch kann die Strahlung in die den jeweiligen Stufenflächen zugeordneten aktiven Bereichen eingekoppelt werden.

Die Stufenflächen sind flächig nebeneinander angeordnet. Eine Verbindungslinie zwischen zwei beliebigen Punkten einer Stufenfläche verläuft nicht durch eine andere Stufenfläche hindurch. Die Stufenflächen können auch andere vergleichsweise einfache geometrische Grundformen, insbesondere mehreckige, etwa dreieckige oder viereckige Grundformen aufweisen.

Die Stufenflächen können insbesondere derart geformt sein, dass die Summe der Grenzlinien zwischen den Stufenflächen minimiert ist. Die Gefahr von an den Grenzflächen auftretenden Leckströmen und eine damit einhergehende verringerte Empfindlichkeit des Strahlungsempfängers kann so weitgehend minimiert werden.

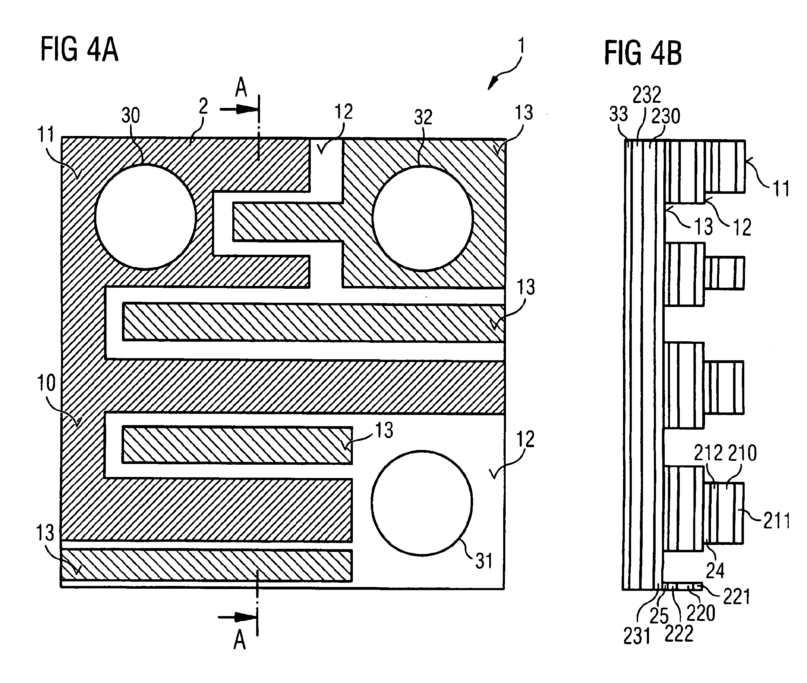

Ein drittes Ausführungsbeispiel für einen Strahlungsempfänger ist in den Figuren 4A und 4B in schematischer Aufsicht und zugehöriger Schnittansicht entlang der Linie AA' dargestellt. Der Schichtaufbau des Halbleiterkörpers 2 kann wie im Zusammenhang mit den Figuren 1 und 2 beschrieben ausgeführt sein. Zur vereinfachten Darstellung sind die passiven Bereiche in der in Figur 4B dargestellten Schnittansicht nicht gezeigt. Diese können aber, wie im Zusammenhang mit den Figuren 1 und 2 beschrieben, vorgesehen und ausgeführt sein.

Im Unterschied zu dem in Figur 3 gezeigten Ausführungsbeispiel sind in diesem Ausführungsbeispiel die Stufenflächen derart angeordnet, dass die Stufenflächen mit einer erhöhten Gleichmäßigkeit über die Hauptstrahlungseintrittsfläche 10 verteilt sind. Insbesondere bei einer räumlich inhomogenen Bestrahlung des Strahlungsempfängers 1 kann so vereinfacht ein zuverlässiges Signal erzeugt werden. Die verbesserte räumlich homogene Empfindlichkeitsverteilung kann erzielt werden, ohne dass der Fertigungsaufwand im Vergleich zu dem im Zusammenhang mit Figur 3 beschriebenen Ausführungsbeispiel wesentlich erhöht wird.

Die dem ersten aktiven Bereich 210 zugeordnete erste Stufenfläche 11 ist zusammenhängend ausgeführt. So kann das in dem ersten aktiven Bereich erzeugte Signal vereinfacht über die obere Anschlussfläche 30 abgegriffen werden.

Die dem zweiten aktiven Bereich 220 zugeordnete zweite Stufenfläche 12 umläuft die erste Stufenfläche 11 im Innenbereich der Hauptstrahlungseintrittsfläche 10. Mit anderen Worten schließt sich die zweite Stufenfläche an die erste Stufenfläche an. Die durch die erste Stufenfläche und die zweite Stufenfläche gemeinsam gebildete Fläche ist somit zusammenhängend. Eine externe Kontaktierung des Strahlungsempfängers mittels der ersten Anschlussfläche 31 ist so vereinfacht. Weiterhin ergeben sich so bei der Herstellung des Strahlungsempfängers erhöhte Herstellungstoleranzen beim Ausbilden der Stufenflächen.

Die dem dritten aktiven Bereich 230 zugeordnete dritte Stufenfläche 13 greift zumindest bereichsweise in die dem ersten aktiven Bereich zugeordnete erste Stufenfläche 11 ein. Die dritte Stufenfläche 13 muss nicht zusammenhängend ausgebildet sein. Vielmehr kann diese inselartige Teilbereiche aufweisen, da die weitere Tunnelschicht 25 auch bei der Herstellung inselartiger Bereiche der dritten Stufenfläche 13 nicht durchtrennt werden muss.

Eine räumlich homogen über die Hauptstrahlungseintrittsfläche 10 verteilte Empfindlichkeit der aktiven Bereiche 210, 220, 230 wird so vereinfacht.

Die Stufenflächen können zumindest bereichsweise streifenförmig ausgebildet sein. Insbesondere kann zumindest eine Stufenfläche, etwa wie im dem Ausführungsbeispiel gezeigt die erste Stufenfläche 11, kammartig ausgebildet sein.

Je nach der lateralen Ausdehnung des Strahlungsempfängers können die Streifen eine Breite zwischen etwa 8 µm und 100 µm, insbesondere zwischen einschließlich 8 µm und einschließlich 50 µm betragen. Ein Mittelpunktsabstand zwischen zwei benachbarten Streifen einer Stufenfläche kann hierbei beispielsweise die doppelte Streifenbreite betragen. Die minimale Streifenbreite ist insbesondere abhängig von Herstellungstoleranzen, etwa der Justagetoleranz bei unterschiedlichen photolithographischen Schritten und der auftretenden Unterätzungen bei nasschemischen Herstellungsprozessen.

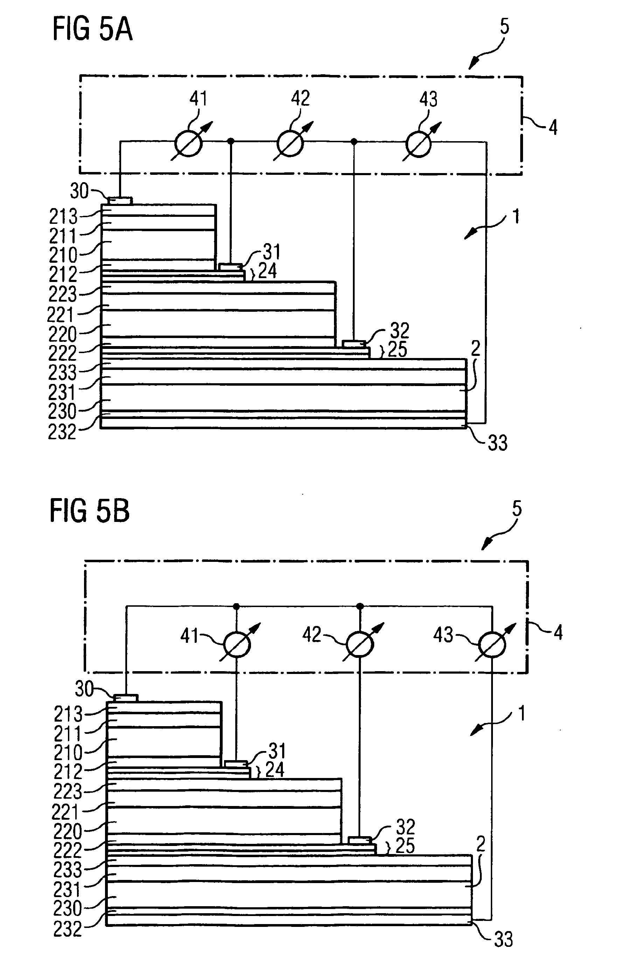

In Figur 5 ist ein erstes Ausführungsbeispiel für einen Farbsensor 5 gezeigt. Der Farbsensor weist einen Strahlungsempfänger 1 auf, der insbesondere wie im Zusammenhang mit den Figuren 1 bis 4B beschrieben ausgeführt sein kann.

Der Farbsensor weist eine Auswerteschaltung 4 auf, die eine erste Auswerteeinheit 41, eine zweite Auswerteeinheit 42 und eine dritte Auswerteeinheit 43 umfasst. Jede Auswerteeinheit ist mit jeweils zwei Anschlussflächen verbunden, wobei die Anschlussflächen jeweils auf unterschiedlichen Seiten des jeweiligen aktiven Bereichs angeordnet sind und auf beiden Seiten des aktiven Bereichs jeweils die nächstgelegene Anschlussfläche darstellen. Beispielsweise ist die erste Auswerteeinheit 41 mit der oberen Anschlussfläche 30 und der Anschlussfläche 31 elektrisch leitend verbunden. Die aktiven Bereiche können jeweils mittels einer Vorspannung oder photovoltaisch betrieben werden. Die Signale der aktiven Bereiche können sequenziell oder parallel abgegriffen werden.

Jede Auswerteeinheit ist dafür vorgesehen, für jeweils einen Farbkanal ein Signal auszugeben.

Ein zweites Ausführungsbeispiel für einen Farbsensor ist in Figur 5B dargestellt. Im Unterschied zu dem im Zusammenhang mit Figur 5A dargestellten Farbsensor sind die Auswerteeinheiten 41, 42, 43 mit einer gemeinsamen Anschlussfläche als Referenzkontakt elektrisch leitend verbunden. In dem gezeigten Ausführungsbeispiel ist die gemeinsame elektrische Anschlussfläche die obere Anschlussfläche 30.

In diesem Fall sind die aktiven Bereiche 210, 220, 230 mittels der Tunnelbereiche 24, 25 elektrisch miteinander in Serie verschaltet. Aus dem an den Anschlussflächen abgegriffenen Signal kann mittels der Auswerteeinheiten, etwa mittels einer arithmetischen Operation wie einer Differenzbildung, für jeden Farbkanal das entsprechende Signal erzeugt werden.

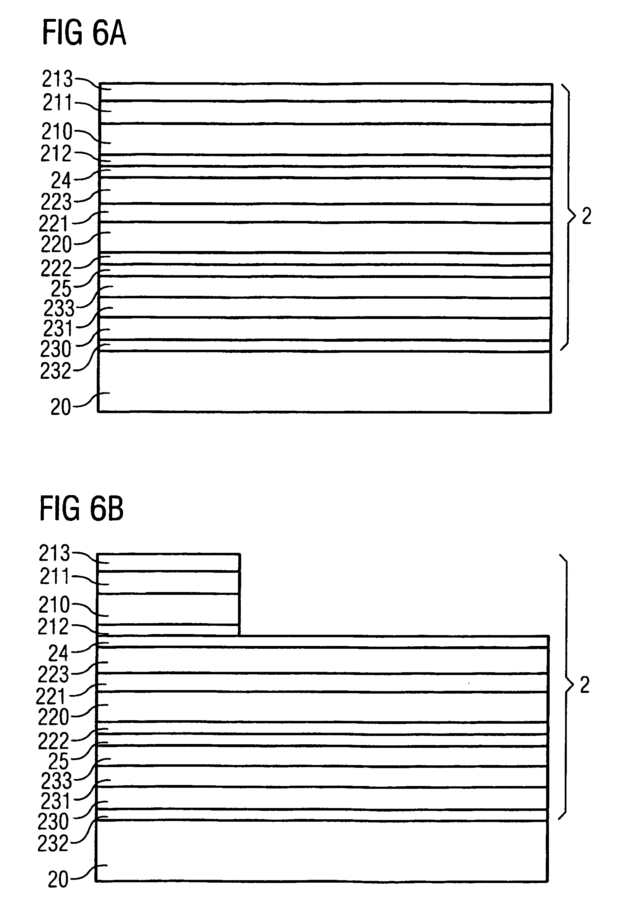

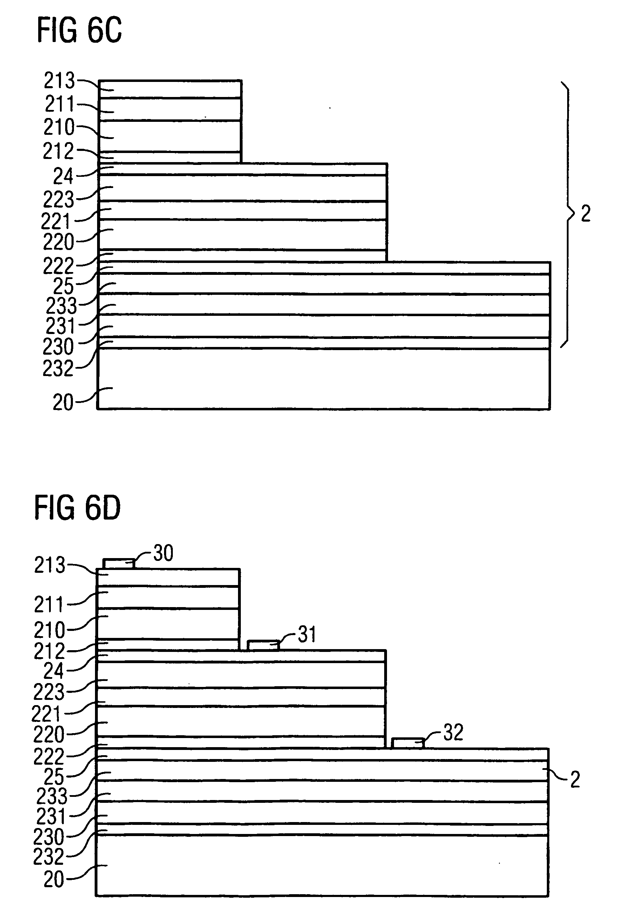

Ein Ausführungsbeispiel für ein Herstellungsverfahren eines Strahlungsempfängers ist anhand von den in den Figuren 6A bis 6F dargestellten Zwischenschritten schematisch in Schnittansicht gezeigt.

Wie in Figur 6A dargestellt, wird ein Halbleiterkörper 2 mit einer Halbleiterschichtenfolge bereitgestellt. Die Halbleiterschichtenfolge des Halbleiterkörpers kann auf einem Aufwachssubstrat 20 epitaktisch, etwa mittels MBE oder MOVPE abgeschieden werden. Die Halbleiterschichtenfolge kann wie in Zusammenhang mit Figur 1 beschrieben ausgeführt sein.

Das Verfahren ist lediglich zur vereinfachten Darstellung für die Herstellung eines einzelnen Strahlungsempfängers gezeigt. Selbstverständlich können mit dem beschriebenen Verfahren mehrere Strahlungsempfänger nebeneinander hergestellt und weiterhin nachfolgend vereinzelt werden. Das Vereinzeln kann beispielsweise mechanisch, etwa mittels Sägens, Schneidens oder Brechens, oder chemisch, etwa mittels nasschemischen oder trockenchemischen Ätzens, erfolgen. Auch ein Lasertrennverfahren kann Anwendung finden.

Wie in Figur 6B dargestellt, wird der zwischen dem ersten aktiven Bereich 210 und dem zweiten aktiven Bereich 220 angeordnete Tunnelbereich 24 bereichsweise freigelegt. Dies erfolgt mittels bereichsweisen Entfernens von Material der darüberliegenden Halbleiterschichten, insbesondere des ersten aktiven Bereichs 210.

Das Entfernen des Materials kann insbesondere mittels nasschemischen Ätzens erfolgen. Hierbei kann der Tunnelbereich 24 derart ausgeführt sein, dass er als Ätzstopp dient. Beispielsweise können phosphidische Halbleitermaterialien und arsenidische Halbleitermaterialien bezüglich eines nasschemischen Ätzprozesses eine hohe Selektivität aufweisen. So kann etwa eine Ätzung mittels Chlorwasserstoff (HCl) phosphidisches Halbleitermaterial effektiv entfernen und auf einem arsenidischen Material mit hoher Selektivität stoppen.

Nachfolgend wird, wie in Figur 6C dargestellt, der weitere Tunnelbereich 25, der zwischen dem zweiten aktiven Bereich 220 und dem dritten aktiven Bereich 230 angeordnet ist, bereichsweise freigelegt. Dies kann wie im Zusammenhang mit Figur 6B beschrieben erfolgen.

Auf den freigelegten Bereichen des Tunnelbereichs 24 beziehungsweise des weiteren Tunnelbereichs 25 kann nachfolgend jeweils eine Anschlussfläche abgeschieden werden. Dies kann in einem gemeinsamen Abscheideprozess erfolgen. Hierfür eignet sich beispielsweise Aufdampfen oder Aufsputtern. Auch eine mehrschichtige Ausbildung der Anschlussflächen kann vorgesehen sein. Weiterhin wird auf dem passiven Bereich 213, der dem ersten aktiven Bereich 210 zugeordnet ist, eine obere Anschlussfläche 30 abgeschieden. Dies kann gemeinsam mit der Anschlussfläche 31 und der weiteren Anschlussfläche 32 erfolgen oder in einem gesonderten Abscheideschritt durchgeführt werden.

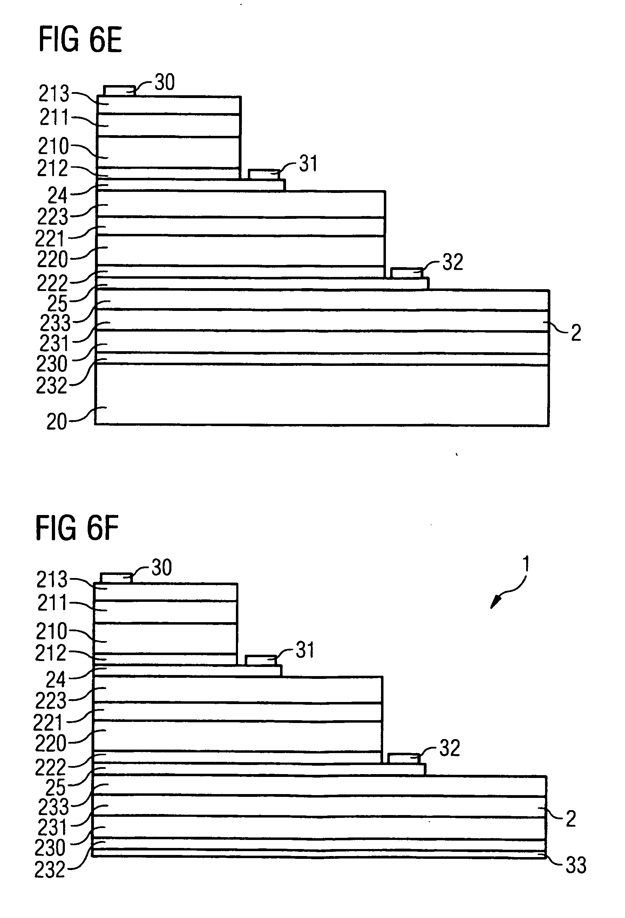

Wie in Figur 6E dargestellt, werden der Tunnelbereich 24 und der weitere Tunnelbereich 25 bereichsweise entfernt. So können die den jeweiligen aktiven Bereichen 220, 230 zugeordneten passiven Bereiche 223 beziehungsweise 233 freigelegt werden. Die Tunnelbereiche können daher für die in den darunter liegenden aktiven Bereichen zu detektierende Strahlung absorbierend ausgebildet sein.

Bei Tunnelbereichen, die derart ausgeführt sind, dass sie für die in den darunterliegenden aktiven Bereichen zu detektierende Strahlung transparent ausgebildet sind, kann auf dieses bereichsweise Entfernen der Tunnelbereiche auch verzichtet werden.

Das Aufwachssubstrat 20 wird, wie in Figur 6F dargestellt, entfernt. Auf der so freigelegten Fläche des Halbleiterkörpers kann die untere Anschlussfläche 33 abgeschieden werden. Die Abscheidung der unteren Anschlussfläche kann wie im Zusammenhang mit den Anschlussflächen 30, 31, 32 beschrieben erfolgen.

Weiterhin kann der Halbleiterkörper 2 zumindest bereichsweise mit einer Schutzschicht versehen werden (nicht explizit dargestellt). Diese kann insbesondere die freiliegenden Seitenflächen des Halbleiterkörpers bedecken. Die Schutzschicht kann beispielsweise ein Oxid, etwa Siliziumoxid oder Titanoxid, ein Nitrid, etwa Siliziumnitrid, oder ein Oxinitrid, etwa Siliziumoxinitrid, enthalten.

Von dem gezeigten Ausführungsbeispiel abweichend, kann das Aufwachssubstrat 20 auch zumindest teilweise in dem Strahlungsempfänger verbleiben. Insbesondere kann das Aufwachssubstrat 20 auch nur bereichsweise entfernt oder vollflächig oder bereichsweise gedünnt werden. Weiterhin können die Herstellungsschritte auch von der beschriebenen Reihenfolge abweichend durchgeführt werden, soweit zweckmäßig.

Die Erfindung ist nicht durch die Beschreibung anhand der Ausführungsbeispiele beschränkt. Vielmehr umfasst die Erfindung jede Kombination von Merkmalen in den Patentansprüchen beinhalten, auch wenn dieses Merkmal oder diese Kombination selbst nicht explizit in den Ausführungsbeispielen angegeben ist.

## Patentansprüche

1. Strahlungsempfänger (1) mit einem Halbleiterkörper (2), der einen ersten aktiven Bereich (210) und einen zweiten aktiven Bereich (220) aufweist, die jeweils zur Detektion von Strahlung vorgesehen sind, wobei
- der erste aktive Bereich (210) und der zweite aktive Bereich (220) in einer vertikalen Richtung voneinander beabstandet sind,
- eine Anschlussfläche (31) für eine externe elektrische Kontaktierung des Halbleiterkörpers (2) zwischen dem ersten aktiven Bereich (210) und dem zweiten aktiven Bereich (220) vorgesehen ist, und
- in vertikaler Richtung zwischen dem ersten aktiven Bereich (210) und dem zweiten aktiven Bereich (220) ein Tunnelbereich (24) angeordnet ist, der mit der Anschlussfläche (31) elektrisch leitend verbunden ist und zwei Tunnelschichten (241, 242) mit voneinander verschiedenen Leitungstypen aufweist,
**dadurch gekennzeichnet, dass**
die Anschlussfläche (31) auf einem über den ersten aktiven Bereich in lateraler Richtung hinausragenden Teilbereich des Tunnelbereichs (24) angeordnet ist.

2. Strahlungsempfänger nach Anspruch 1,
bei dem der Halbleiterkörper (2) auf der dem ersten aktiven Bereich (210) abgewandten Seite des zweiten aktiven Bereichs (220) einen dritten aktiven Bereich (230) aufweist, wobei zwischen dem zweiten aktiven Bereich (220) und dem dritten aktiven Bereich (230) ein weiterer Tunnelbereich (25) angeordnet ist, der mit einer weiteren Anschlussfläche (32) elektrisch leitend verbunden ist, wobei die weitere Anschlussfläche auf einem über den zweiten aktiven Bereich in lateraler Richtung hinausragenden Teilbereich des weiters Tunnelbereichs (25) angeordnet ist.

3. Strahlungsempfänger nach Anspruch 1 oder 2,
wobei der Strahlungsempfänger eine Struktur gestapelter Dioden aufweist, wobei die Polarität der Dioden bezüglich einer Haupteinstrahlungsrichtung jeweils gleichartig ist.

4. Strahlungsempfänger nach einem der Ansprüche 1 bis 3,
bei dem eine Hauptstrahlungseintrittsfläche (10) des Halbleiterkörpers (2), die den Halbleiterkörper in vertikaler Richtung begrenzt, stufenartig ausgebildet ist und jedem aktiven Bereich (210, 220, 230) eine Stufenfläche (11, 12, 13) der Hauptstrahlungseintrittsfläche (10) zugeordnet ist, wobei jeweils zwischen zwei benachbarten aktiven Bereichen (210, 220, 230) eine Stufenfläche (11, 12, 13) ausgebildet ist.

5. Strahlungsempfänger nach Anspruch 4,
bei dem zumindest zwei Stufenflächen (11, 12, 13) in Aufsicht flächig nebeneinander angeordnet sind.

6. Strahlungsempfänger nach Anspruch 4,
bei dem zumindest zwei Stufenflächen (11, 12, 13) in Aufsicht bereichsweise ineinander greifen.

7. Strahlungsempfänger nach einem der vorangehenden Ansprüche,
bei dem der erste aktive Bereich (210) dem zweiten aktiven Bereich (220) entlang einer Hauptrichtung des Strahlungseintritts vorgeordnet ist, wobei die dem ersten aktiven Bereich (210) zugeordnete erste Stufenfläche (11) zusammenhängend ausgebildet ist.

8. Strahlungsempfänger nach einem der vorangehenden Ansprüche,
bei dem die aktiven Bereiche (210, 220, 230) jeweils bei einer Peak-Wellenlänge ein Detektionsmaximum aufweisen und die Peak-Wellenlängen voneinander beabstandet sind, wobei bei dem die Peak-Wellenlängen entlang der Hauptrichtung des Strahlungseintritts zunehmen.

9. Strahlungsempfänger nach einem der Ansprüche 1 bis 7,
bei dem die aktiven Bereiche (210, 220, 230) jeweils bei einer Peak-Wellenlänge ein Detektionsmaximum aufweisen und die Peak-Wellenlängen voneinander beabstandet sind, wobei entlang der Hauptrichtung des Strahlungseintritts zumindest ein aktiver Bereich (210, 220, 230) eine kleinere Peak-Wellenlänge aufweist als ein vorgeordneter aktiver Bereich (210, 220, 230).

10. Strahlungsempfänger nach einem der vorangehenden Ansprüche,
bei dem zumindest einem der aktiven Bereiche (210, 220, 230) ein passiver Bereich (213, 223,233) als Filterschicht vorgeordnet ist, der zur Formung einer kurzwelligen Flanke eines diesem aktiven Bereich (210, 220, 230) zugeordneten spektralen Detektionsbereichs vorgesehen ist.

11. Strahlungsempfänger nach einem der vorangehenden Ansprüche,
bei dem zumindest einer der aktiven Bereiche (210, 220, 230) ein III-V-Verbindungshalbleitermaterial enthält.

12. Strahlungsempfänger nach einem der vorangehenden Ansprüche,
der zum Betrieb in einem Farbsensor (5) vorgesehen ist, wobei der Farbsensor (5) eine Mehrzahl von Farbkanälen aufweist.

13. Verfahren zur Herstellung eines Strahlungsempfängers (1) mit dem Schritt:
(a) Bereitstellen eines Halbleiterkörpers (2), der einen ersten aktiven Bereich (210) und einen zweiten aktiven Bereich (220) aufweist, wobei die aktiven Bereiche (210, 220) jeweils zur Detektion von Strahlung vorgesehen sind und wobei in vertikaler Richtung zwischen dem ersten aktiven Bereich (210) und dem zweiten aktiven Bereich (220) ein Tunnelbereich (24) angeordnet ist, der zwei Tunnelschichten (241, 242) mit voneinander verschiedenen Leitungstypen aufweist; **gekennzeichnet durch** die Schritte:
(b) Freilegen des Tunnelbereichs (24), wobei der erste aktive Bereich (210) bereichsweise entfernt wird; und
(c) Ausbilden einer Anschlussfläche (31) auf dem Tunnelbereich (24), wobei die Anschlussfläche (31) auf einem über den ersten aktiven Bereich in lateraler Richtung hinausragenden Teilbereich des Tunnelbereichs angeordnet ist.

14. Verfahren nach Anspruch 13, bei dem der Halbleiterkörper (2) epitaktisch auf einem Aufwachssubstrat (20) abgeschieden wird.

15. Verfahren nach Anspruch 13 oder 14, bei dem ein Strahlungsempfänger (1) gemäß einem der Ansprüche 1 bis 12 hergestellt wird.

## Claims

1. Radiation receiver (1) comprising a semiconductor body (2) having a first active region (210) and a second active region (220), which are provided in each case for detecting radiation, wherein
- the first active region (210) and the second active region (220) are spaced apart from one another in a vertical direction,
- provision is made of a connection area (31) for an external electrical contact-connection of the semiconductor body (2) between the first active region (210) and the second active region (220), and
- a tunnel region (24) is arranged in a vertical direction between the first active region (210) and the second active region (220), said tunnel region being electrically conductively connected to the connection area (31) and having two tunnel layers (241, 242) having mutually different conduction types, **characterized in that**
the connection area (31) is arranged on a partial region of the tunnel region (24) which projects beyond the first active region in a lateral direction.

2. Radiation receiver according to Claim 1,
wherein the semiconductor body (2) has a third active region (230) on that side of the second active region (220) which faces away from the first active region (210), wherein a further tunnel region (25) is arranged between the second active region (220) and the third active region (230), said further tunnel region being electrically conductively connected to a further connection area (32), wherein the further connection area is arranged on a partial region of the further tunnel region (25) which projects beyond the second active region in a lateral direction.

3. Radiation receiver according to Claim 1 or 2, wherein the radiation receiver has a structure of stacked diodes, wherein the polarity of the diodes with respect to a main irradiation direction is in each case of the same type.

4. Radiation receiver according to any of Claims 1 to 3,
wherein a main radiation entrance area (10) of the semiconductor body (2), which area delimits the semiconductor body in a vertical direction, is embodied in a step-like fashion and a step area (11, 12, 13) of the main radiation entrance area (10) is assigned to each active region (210, 220, 230), wherein a step area (11, 12, 13) is formed in each case between two adjacent active regions (210, 220, 230).

5. Radiation receiver according to Claim 4,
wherein at least two step areas (11, 12, 13) are arranged alongside one another areally in plan view.

6. Radiation receiver according to Claim 4,
wherein at least two step areas, (11, 12, 13) intermesh in regions in plan view.

7. Radiation receiver according to any of the preceding claims,
wherein the first active region (210) is disposed upstream of the second active region (220) along a main direction of the radiation entrance, wherein the first step area (11) assigned to the first active region (210) is embodied in a continuous fashion.

8. Radiation receiver according to any of the preceding claims,
wherein the active regions (210, 220, 230) in each case have a detection maximum at a peak wavelength and the peak wavelengths are spaced apart from one another, wherein the peak wavelengths increase along the main direction of the radiation entrance.

9. Radiation receiver according to any of Claims 1 to 7,
wherein the active regions (210, 220, 230) in each case have a detection maximum at a peak wavelength and the peak wavelengths are spaced apart from one another, wherein, along the main direction of the radiation entrance, at least one active region (210, 220, 230) has a smaller peak wavelength than an active region (210, 220, 230) disposed upstream.

10. Radiation receiver according to any of the preceding claims,
wherein a passive region (213, 223, 233) as filter layer is disposed upstream of at least one of the active regions (210, 220, 230), said passive region being provided for shaping a short-wave flank of a spectral detection range assigned to said active region (210, 220, 230).

11. Radiation receiver according to any of the preceding claims,
wherein at least one of the active regions (210, 220, 230) contains a III-V compound semiconductor material.

12. Radiation receiver according to any of the preceding claims,
which is provided for operation in a colour sensor (5), wherein the colour sensor (5) has a plurality of colour channels.

13. Method for producing a radiation receiver (1) comprising the following step:
(a) providing a semiconductor body (2) having a first active region (210) and a second active region (220), wherein the active regions (210, 220) are provided in each case for detecting radiation and wherein a tunnel region (24) is arranged in a vertical direction between the first active region (210) and the second active region (220), said tunnel region having two tunnel layers (241, 242) having mutually different conduction types; **characterized by** the following steps:
(b) exposing the tunnel region (24), wherein the first active region (210) is removed in regions; and
(c) forming a connection area (31) on the tunnel region (24) wherein the connection area (31) is arranged on a partial region of the tunnel region which projects beyond the first active region in a lateral direction.

14. Method according to Claim 13,
wherein the semiconductor body (2) is deposited epitaxially on a growth substrate (20).

15. Method according to Claim 13 or 14,
wherein a radiation receiver (1) according to any of Claims 1 to 12 is produced.

## Revendications

1. Récepteur de rayonnement (1) comprenant un corps semi-conducteur (2) qui présente une première région active (210) et une deuxième région active (220) dont chacune est prévue pour détecter un rayonnement, dans lequel
- la première région active (210) et la deuxième région active (220) sont espacées l'une de l'autre dans une direction verticale,
- une surface de raccordement (31) destinée à un contact électrique externe du corps semi-conducteur (2) est prévue entre la première région active (210) et la deuxième région active (220), et
- une région de tunnel (24) est disposée dans la direction verticale entre la première région active (210) et la deuxième région active (220), laquelle région peut être connectée de manière électriquement conductrice à la surface de raccordement (31) et présente deux couches de tunnel (241, 242) ayant des types de conductivité différents l'un de l'autre,
**caractérisé en ce que**
la surface de raccordement (31) est disposée sur une sous-région de la région de tunnel (24) débordant latéralement sur la première région active.

2. Récepteur de rayonnement selon la revendication 1, dans lequel le corps semi-conducteur (2) présente sur la face de la deuxième région active (220) qui est opposée à la première région active (210) une troisième région active (230), dans lequel, entre la deuxième région active (220) et la troisième région active (230) est disposée une région de tunnel supplémentaire (25) qui est connectée de manière électriquement conductrice par une surface de raccordement (32) supplémentaire, dans lequel la surface de raccordement supplémentaire est disposée sur une sous-région de la région de tunnel supplémentaire (25) débordant latéralement sur la deuxième région active.

3. Récepteur de rayonnement selon la revendication 1 ou 2, dans lequel le récepteur de rayonnement présente une structure de diodes superposées dans lequel la polarité des diodes est respectivement du même type qu'une direction de rayonnement incident principal.

4. Récepteur de rayonnement selon l'une quelconque des revendications 1 à 3, dans lequel la surface d'incidence de rayonnement principal (10) du corps semi-conducteur (2) qui délimite le corps semi-conducteur en direction verticale, est réalisée de manière échelonnée et dans lequel une surface échelonnée (11, 12, 13) de la surface d'incidence de rayonnement principal (10) est associée à chaque région active (210, 220, 230), dans lequel une surface échelonnée (11, 12, 13) respective est réalisée entre deux régions actives voisines (210, 220, 230).

5. Récepteur de rayonnement selon la revendication 4, dans lequel au moins deux surfaces échelonnées (11, 12, 13) sont disposées côte à côte sur toute la surface en vue de dessus.

6. Récepteur de rayonnement selon la revendication 4, dans lequel au moins deux surfaces échelonnées (11, 12, 13) s'interpénètrent région par région en vue de dessus.

7. Récepteur de rayonnement selon l'une quelconque des revendications précédentes, dans lequel la première région active (210) est disposée à l'avant de la deuxième région active (220) dans une direction principale d'incidence du rayonnement, dans lequel la première surface échelonnée (11) associée à la première région active (210) est réalisée d'un seul tenant.

8. Récepteur de rayonnement selon l'une quelconque des revendications précédentes, dans lequel les régions actives (210, 220, 230) présentent respectivement un maximum de détection à une longueur d'onde crête et les longueurs d'onde crêtes sont espacées les unes des autres, dans lequel les longueurs d'onde crêtes croissent dans la direction principale d'incidence du rayonnement.

9. Récepteur de rayonnement selon l'une quelconque des revendications 1 à 7, dans lequel les régions actives (210, 220, 230) présentent respectivement un maximum de détection à une longueur d'onde crête et les longueurs d'onde crêtes sont espacées les unes des autres, dans lequel au moins une région active (210, 220, 230) présente une plus faible longueur d'onde crête dans la direction principale d'incidence du rayonnement qu'une région active (210, 220, 230) disposée en amont.

10. Récepteur de rayonnement selon l'une quelconque des revendications précédentes, dans lequel une région passive (213, 223, 233) est disposée en amont d'au moins l'une des régions actives (210, 220, 230) en tant que couche de filtre qui est prévue pour former un flanc d'ondes courtes d'une région de détection spectrale associée à cette région active (210, 220, 230).

11. Récepteur de rayonnement selon l'une quelconque des revendications précédentes, dans lequel au moins l'une des régions actives (210, 220, 230) contient un matériau semi-conducteur de connexion de type III-V.

12. Récepteur de rayonnement selon l'une quelconque des revendications précédentes, qui est prévu pour fonctionner dans un capteur de couleur (5), dans lequel le capteur de couleur (5) comprend une pluralité de canaux de couleur.

13. Procédé de fabrication d'un récepteur de rayonnement (1) comprenant les étapes suivantes :
(a) la préparation d'un corps semi-conducteur (2), qui présente une première région active (210) et une deuxième région active (220), dans lequel les régions actives (210, 220) sont respectivement prévues pour la détection de rayonnement et dans lequel, dans la direction verticale entre la première région active (210) et la deuxième région active (220), est disposée une région de tunnel (24) qui présente deux couches de tunnel (241, 242) ayant des types de conductivité différents l'un de l'autre, **caractérisé par** les étapes suivantes :
(b) l'exposition de la région de tunnel (24), la première région active (210) étant enlevée région par région ; et
(c) la réalisation d'une surface de raccordement (31) sur la région de tunnel (24), la surface de raccordement (31) étant disposée sur une sous-région de la région de tunnel débordant latéralement sur la première région active.

14. Procédé selon la revendication 13, dans lequel le corps semi-conducteur (2) est déposé par voie épitaxiale sur un substrat de croissance (20).

15. Procédé selon la revendication 13 ou 14, dans lequel un récepteur de rayonnement (1) selon l'une quelconque des revendications 1 à 12 est fabriqué.
